# EUROPEAN PATENT APPLICATION

(11) **EP 4 160 706 A1**
(43) Date of publication of application: **05.04.2023**
(21) Application number: 21200440.2
(22) Date of filing: 01.10.2021
(51) Int. Cl.: H01L 41/113, H01L 41/316, H01L 41/319, G01D 21/02

(54) **METHOD FOR PRODUCING A MULTI-STIMULI SENSOR DEVICE**

(71) Applicant: Technische Universität Graz, 8010 Graz (AT); Joanneum Research Forschungsgesellschaft mbH, 8010 Graz (AT)
(72) Inventor: Coclite, Anna Maria, 8010 Graz (AT); Abu Ali, Taher, 8020 Graz (AT); Stadlober, Barbara, 8044 Graz (AT)
(74) Representative: Patentanwaltskanzlei Matschnig & Forsthuber OG

(57) **Abstract**

Method for producing a multi-stimuli sensor device (1), said method comprising the following steps: a) providing a substrate layer (2) consisting of flexible material; b) creating a first electrode layer (3) by depositing electrical conductive material on the substrate layer (2); c) creating a flexible resin layer (4) by depositing UV-curable resin on top of the first electrode layer (3); d) creating a pattern of recesses (4a) in the flexible resin; e) curing the patterned flexible resin layer (4); f) creating a piezoelectric layer (5) on top of the cured patterned resin layer (4); g) creating a layer of multi-stimuli sensitive hydrogel (5) on top of the piezoelectric layer (5); h) creating a second electrode layer (7) by depositing electrical conductive.

## Description

### Field of the invention and description of prior art

The invention relates to a method for producing a multi-stimuli sensor device.

The invention also relates to a method for producing a multi-stimuli sensitive and high resolution artificial skin device.

Furthermore, the invention relates to a multi-stimuli sensor device as well as a multi-stimuli sensitive artificial skin device.

The Human skin comprises a specialized, complex system where surrounding environmental stimuli are detected and transmitted to the brain. Although, remarkable progress has been achieved in the understanding of mechano- and thermosensation in the human skin, replication of these sophisticated sensory systems in artificial skin remains a challenge. Already existing skin-like sensors usually consist of an array of selective sensitive areas, which are capable of measuring more than one property. Artificial skins in robotics use a pressure sensitive material to detect the environment through touch and transmit the detected signal to a central processing unit. Tactile recognition in such artificial skin is achieved by an array of transistors connected with the pressure sensitive layer. An example of artificial skin was produced by Javey's research group in Berkley from nanowire transistors of Ge/Si on a polyimide substrate covered by a pressure sensitive rubber (Takei et al., Nature Materials, 2010, 9, 821-826). The spatial resolution achieved with this approach was 2.5 mm. Studies have shown that the limiting spatial resolution of human fingertips is approximately 1 mm. Skin normally experiences multi-axial forces and is subjected to a range of simultaneous stimuli. This heterogeneity in applied forces suggests the need for location-specific optimization of sensors in artificial skins.

Kim et al. (J. Kim, M. Lee, H. J. Shim, R. Ghaffari, H. Rim Cho, D. Son, Nature Comm., 2014, 5, 57472014) have achieved such location-specificity in an artificial skin equipped with a series of different sensors for strain, pressure and temperature in a multi-layered device. A specific sensor for each stimulus was used and assembled into the matrix with a laborious architecture.

It is therefore an object of the present invention to simplify and optimize multi-stimuli sensor device architecture in order to increase the spatial resolution. A simplification of the multi-stimuli sensor device architecture is beneficial for costs and functionality, and to avoid interferences among the different sensors. Such simplification can only be achieved by significant advances in smart material design.

This object is solved with a method according to claim 1, a method according to claim 10, a multi-stimuli sensor device according to claim 11 and a multi-stimuli sensitive artificial skin device according to claim 12. Preferred embodiments are described in depended claims.

### Summary of the invention

According to a first aspect of the invention, the method for producing a multi-stimuli sensor device comprises the following steps:
a) providing a substrate layer consisting of flexible material, in particular PET (Polyethylene terephthalate) and/or PDMS (Polydimethylsiloxane) or mixtures thereof, the substrate layer having a first side for receiving an electrode,
b) creating a first electrode layer by depositing electrical conductive material on the substrate layer of step a) in order to obtain a bottom electrode,
c) creating a flexible resin layer by depositing UV-curable resin on top of the first electrode layer of step b),
d) creating a pattern of recesses in the flexible resin layer of step c) by pressing a stamp having multiple protrusions into the flexible resin layer of step c), wherein each recess corresponds with a protrusion of the stamp,
e) curing the patterned flexible resin layer obtained in step d) by irradiating UV light onto said patterned resin layer and removing the stamp,
f) creating a piezoelectric layer on top of the cured patterned resin layer obtained in step e) by coating the surface of the patterned resin layer including its recesses with a layer of piezoelectric material,
g) creating a layer of multi-stimuli sensitive hydrogel on top of the piezoelectric layer obtained in step f) by applying multi-stimuli sensitive hydrogel on the piezoelectric layer of step f) fully filling the coated recesses of the piezoelectric layer,
h) creating a second electrode layer by depositing electrical conductive material on the layer of multi-stimuli sensitive hydrogel obtained in step g) in order to obtain a top electrode.

Multi-stimuli sensitive means that the respective hydrogel or device is sensitive to at least two different kinds of stimuli. This stimuli can be selected from a group comprising temperature, humidity, pressure, pH, visible light. A multi-stimuli sensor device created with the method according to the invention advantageously can measure e.g. temperature, humidity and pressure with a spatial resolution down to 1 mm² or lower. The multi-stimuli sensor device is preferably composed of an array of multi-stimuli-responsive nanorods (one recess filled with hydrogel can be described as a nanorod), wherein the nanorods can have a core-shell structure composed of a multi-stimuli sensitive hydrogel (core) and a piezoelectric material (shell). The stimuli coming from the environment, such as humidity or temperature changes, can cause the multi-stimuli sensitive hydrogel to expand or decrease its volume (swelling or shrinking). The volume change of the hydrogel can then be detected by the piezoelectric material of the piezoelectric layer and can therefore be transformed into a measurable electrical signal. Pressure for example (i.e. touch or bending) can be sensed directly by the piezoelectric material. The different stimuli can be recognized as they can result in a different degree of volume change of the hydrogel, and therefore different pressure intensities can be applied on the piezoelectric material and can be transformed in different signal ranges. The substrate layer can also consist of polyimide (PI) or thermoplastic polyurethane (TPU).

It can be provided that the electrical conductive material deposited in step b) and or h) to create the respective electrode consists of Indium Tin Oxide, gold, silver or mixtures thereof. For enhancing the adhesion of the electrode layer on a substrate layer, a chrome layer can be added between the electrode layer, e.g. a silver layer, and the substrate layer. Preferably, the electrode can also consist of palladium, copper, aluminium or mixtures thereof.

It can be provided that the UV-curable resin deposited in step c) is a compound based on (metha)acrylates, e.g. polyurethane acrylate (PUA). Advantageously, PUA provides an advantageous mix of stability and flexibility. Additionally, the compound can also comprise a photoinitiator and, optionally, an additive for anti-sticking or superwetting.

It can be provided that the substrate layer consists of flexible synthetic material.

It can be provided that the first side of the substrate layer is essentially flat shaped. The flat shape is advantageous when applying the piezoelectric layer on the substrate layer.

It can be provided that the piezoelectric layer of step f) has a thickness of at least 10 nm and preferably a maximum thickness of 60% of the diameter of the corresponding recess of step d). At the preferred thickness of at least 10 nm the piezoelectric material can provide sufficient piezoelectric properties to detect the change of volume of the hydrogel.

It can be provided that the piezoelectric layer consists of zinc oxide or polyvinylidenfluoride or aluminium nitride. Advantageously, zinc oxide can be applied to the cured patterned resin layer by atomic layer deposition methods. Advantageously, polyvinylidenfluoride can be applied to the cured patterned resin layer using initiated Chemical Vapor Deposition methods. To enhance the piezoelectric properties, the substrate temperature can be held at a preferred value or interval during the atomic layer deposition of the piezoelectric layer. It can also be provided that polyvinylidenfluoride can be applied to the cured patterned resin layer by thermal evaporation. To enhance the piezoelectric properties, the substrate temperature can be held at a preferred value or interval during the deposition of the piezoelectric layer.

It can be provided that the piezoelectric layer is created by using initiated Chemical Vapor Deposition (iCVD) or atomic layer deposition, in particular plasma enhanced atomic layer deposition (PEALD), or thermal evaporation. Advantageously, said methods provide an evenly distributed piezoelectric layer with an essentially even thickness across the layer. Advantageously, both these techniques are driven by surface-limited reactions, which can ensure highly conformal coating and/or filling of the recesses. Other conformal coatings can be obtained by thermal ALD or by molecular layer deposition. Thermal ALD would allow to deposit other piezoelectric materials, for example aluminium nitride or polyvinylidenfluoride. The tunability of the material properties with the deposition conditions is an advantageous characteristic of the (PE)ALD processes, i.e. all materials deposited with such techniques can be tuneable.

It can be provided that the hydrogel of step g) is selected from the following group of hydrogels: poly N-Vinyl Caprolactame (pNVCL), poly-N-isopropylacrylamide (pNIPAAm), poly-hydroxyethylacrylate (pHEMA) pure and/or crosslinked and/or functionalized with azobenzene, poly(N,N-diethylacrylamide) (pDEEAm). Advantageously, pNVCL is sensitive to temperature and humidity, wherein the response critical temperature of pNVCL can be tuned with molecular weight and crosslinking. Advantageously, pNIPAAm is sensitive to temperature and humidity. Advantageously, pHEMA pure and/or crosslinked and/or functionalized with azobenzene is a highly studied hydrogel which is sensitive to humidity and visible light if functionalized with azobenzene. Advantageously, pDEEAm is sensitive to temperature and humidity and is easily deposited with iCVD.

According to the invention the method for producing a multi-stimuli sensitive and high resolution artificial skin device comprises the following step:
a) producing the artificial skin device by producing an array of mechanically connected multi-stimuli sensor devices, wherein each multi-stimuli sensor device is obtained by a method according to the invention, wherein the substrate layer extends along all the multi-stimuli device as a single piece thus mechanically connecting neighbouring multi-stimuli sensor devices with each other, wherein the bottom electrodes of multi-stimuli sensor devices are separated from neighbouring bottom electrodes of multi-stimuli sensor devices and/or wherein the top electrodes of multi-stimuli sensor devices are separated from neighbouring top electrodes of multi-stimuli sensor devices, wherein each multi-stimuli sensor device has a sensing surface area below 1mm².

Advantageously, the multi-stimuli sensitive and high resolution artificial skin device has a spatial resolution of 1 mm² or below. The sensing surface area of the multi-stimuli sensor is the area that is covered on the surface of the skin device.

According to another aspect of the invention the multi-stimuli sensor device comprises:
- a substrate layer consisting of flexible material, in particular PET (Polyethylene terephtalate) and/or PDMS (Polydimethylsiloxan) or mixtures thereof, the substrate layer having a first side for receiving an electrode,
- a first electrode layer arranged on top of the substrate layer in order to obtain a bottom electrode,
- a flexible patterned resin layer on top of the first electrode layer, having multiple recesses in the flexible resin layer,
- a piezoelectric layer on top of the patterned resin layer, said piezoelectric layer coating the surface of the patterned resin layer including its recesses with a layer of piezoelectric material,
- a layer of multi-stimuli sensitive hydrogel on top of the piezoelectric layer fully filling the coated recesses of the piezoelectric layer,
- a second electrode layer on top of the layer of multi-stimuli sensitive hydrogel in order to obtain a top electrode.

According to yet another aspect of the invention the multi-stimuli sensitive artificial skin device comprises an array of mechanically connected multi-stimuli sensor devices, wherein each multi-stimuli sensor device is obtained by a method according to the invention, wherein the substrate layer extends along all the multi-stimuli device as a single piece thus mechanically connecting neighbouring multi-stimuli sensor devices with each other, wherein the bottom electrodes of multi-stimuli sensor devices are separated from neighbouring bottom electrodes of multi-stimuli sensor devices and/or wherein the top electrodes of multi-stimuli sensor devices are separated from neighbouring top electrodes of multi-stimuli sensor devices, wherein each multi-stimuli sensor device has a surface area below 1 mm².

It can be provided that the sensing surface of each multi-stimuli sensor device is smaller than 1 mm². Advantageously, due to the size of the sensing surface, the sensor has a high resolution, which is equal or lower than the sensing resolution of human skin.

### Brief description of the drawings

In the following, in order to further demonstrate the present invention, illustrative and non-restrictive embodiments are discussed, as shown in the drawings, wherein:
Fig. 1 shows steps of the method according to the invention;
Fig. 2 shows a perspective view of the production steps of the multi-stimuli sensor shown in Fig. 1;
Fig. 3 shows a one recess of a multi-stimuli sensor device in two different states;
Fig. 4 shows a SEM image of a PUA stamp;
Fig. 5 shows a XRD pattern of ZnO grown on PET at different substrate temperatures;
Fig. 6 shows a SEM image of a substrate layer (PUA) with a piezoelectric layer (ZnO) and a hydrogel layer;
Fig. 7 shows a graph of generated piezoelectric charge as a function of applied force/pressure;
Fig. 8 to 11 show graphs of generated piezoelectric charge in response to humidity at various temperatures;
Fig. 12 shows a graph of generated piezoelectric charge in response to temperature.

### Detailed description of embodiments of the invention

In the following figures identical reference signs refer to identical features unless expressly depicted otherwise. The reference signs are only for informational purpose and do not delimit the scope of protection.

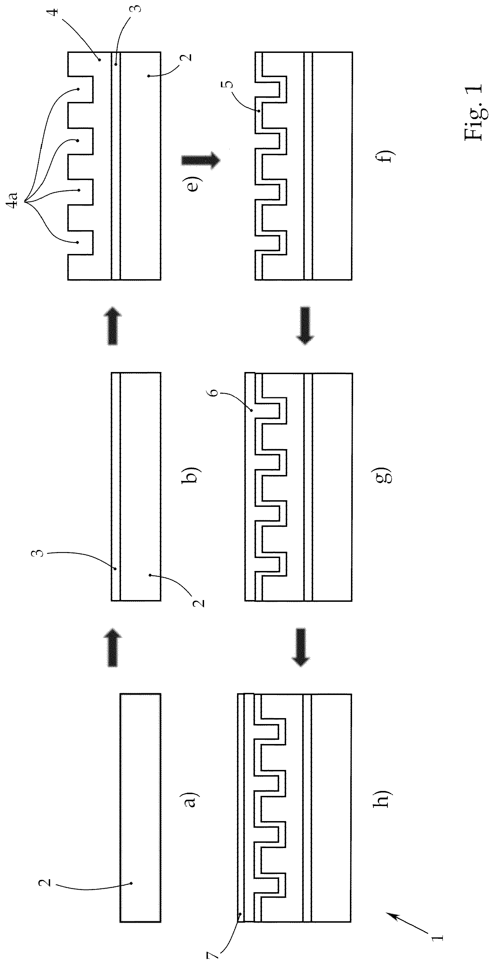

Fig. 1 shows steps of the method for producing a multi-stimuli sensor device 1 according to the invention. The method comprises the steps a) to h). In Fig. 1 not all steps are shown for the sake of simplicity.

Step a) includes providing a substrate layer 2 consisting of flexible material, in particular PET (Polyethylene terephtalate) and/or PDMS (Polydimethylsiloxan) or mixtures thereof, wherein the substrate layer 2 having a first side for receiving an electrode. The substrate layer 2 can consist of flexible synthetic material. Preferably, the first side of the substrate layer 2 is essentially flat shaped.

Step b) includes creating a first electrode layer 3 by depositing electrical conductive material on the substrate layer 2 of step a) in order to obtain a bottom electrode. The electrical conductive material deposited in step b) and or h) to create the respective electrode can consist of gold, silver or mixtures thereof. For instance, a thin optional chromium layer (thickness of about 2.5 nm) is deposited using e-beam evaporation, followed by a 50 nm silver layer, similarly with e-beam evaporation. The silver layer serves as a bottom electrode, the use of the optional chromium layer serves as an adhesion promoter between the silver and the substrate.

Step c) includes creating a flexible resin layer by depositing UV-curable resin on top of the first electrode layer 3 of step b). In one embodiment ultraviolet nanoimprint lithography (UV-NIL) is utilized to pattern a UV-curable polyurethane-acrylate (PUA) based resin. This step is not shown in Fig. 1.

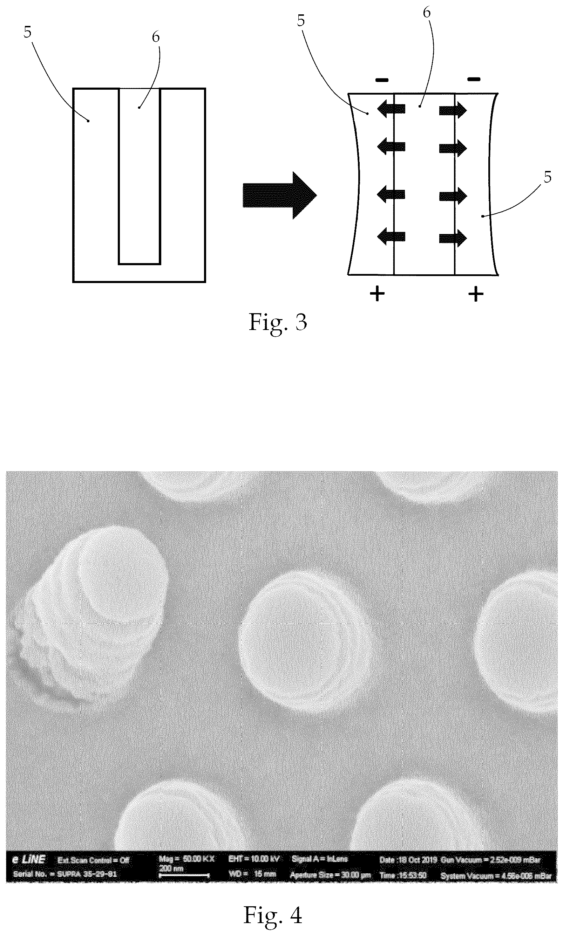

Step d) includes creating a pattern of recesses 4a in the flexible resin layer of step c) by pressing a stamp (Fig. 4) having multiple protrusions into the flexible resin layer of step c), wherein each recess 4a corresponds with a protrusion of the stamp. Upon exposure to a UV source, the resin can be cured and hardened. For instance, the recesses 4a can be created by a PUA stamp (an example is shown in Fig. 4), wherein the protrusions can have a length of 500 nm and a diameter of 500 nm. The diameter and depth of the recesses 4a are preferably below 1 mm. The lower the diameter the higher the resolution. A cylindrical shape of the recesses 4a can be advantageous, but a conical shape can be easier to create since the stamps are usually not perfect cylinders. With a cylindrical shape the thickness of the hydrogel in the recesses 4a can be essentially the same in the whole depth of the recess 4a, which can result in a uniform distribution of forces and therefore increase the accuracy of the sensor. This step is not shown in Fig. 1.

Step e) includes removing the stamp and curing the patterned flexible resin layer obtained in step d) by irradiating UV light onto said patterned resin layer 4.

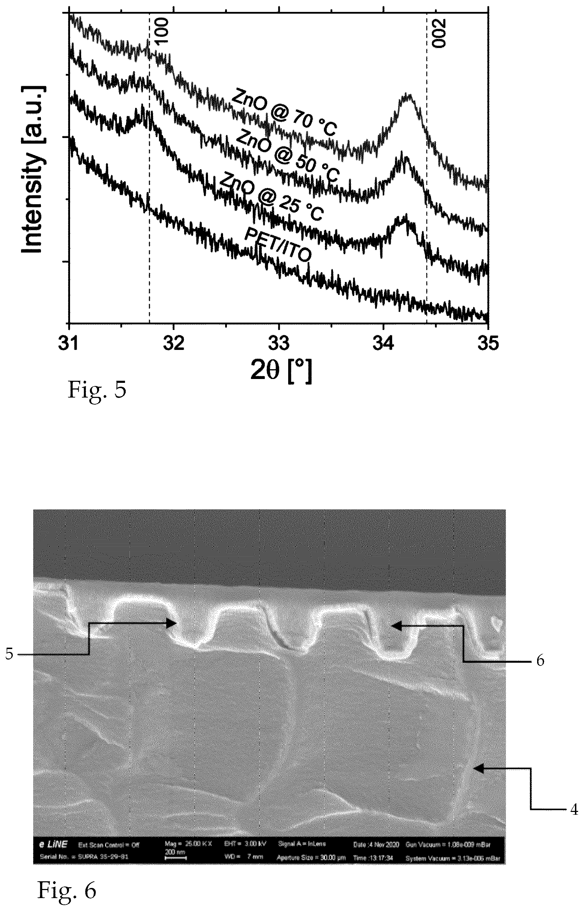

Step f) includes creating a piezoelectric layer 5 on top of the cured patterned resin layer 4 obtained in step e) by coating the surface of the patterned resin layer 4 including its recesses 4a with a layer of piezoelectric material. The piezoelectric layer 5 can have a thickness of at least 10 nm and preferably a maximum thickness of 50% of the diameter of the corresponding recess of step d). The piezoelectric layer 5 can consist of zinc oxide or polyvinylidenfluoride or aluminium nitride. In one embodiment, deposition of piezoelectric zinc oxide (ZnO) onto the patterned resin layer 4 is done using plasma enhanced atomic layer deposition (PEALD). The cyclic process can consist of four sub-cycles, which deposit highly resistive and piezoelectric films with Angstrom level thickness control. Tuning of the piezoelectric properties can be achieved by controlling the substrate temperature during deposition. At room temperature, ZnO films are deposited with a (100) preferential crystallographic orientation. Increasing the substrate temperature can switch the preferred crystallographic orientation from (100) to (002), this can be seen in Fig. 5. Enhanced (002) orientation can strengthen the piezoelectric output for mechanical excitations along the material's c-axis. ZnO films can be deposited by PEALD at temperatures above 200°C, however, due to the thermal stability of flexible substrates, depositions are preferably performed between 25°C and 75°C. In one embodiment, 50 nm of ZnO is deposited.

Step g) includes creating a layer of multi-stimuli sensitive hydrogel 6 on top of the piezoelectric layer 5 obtained in step f) by applying multi-stimuli sensitive hydrogel on the piezoelectric layer 5 of step f) fully filling the coated recesses 4a of the piezoelectric layer 5. The hydrogel of step g) can be selected from the following group of hydrogels: poly N-Vinyl Caprolactame (pNVCL), poly-N-isopropylacrylamide (pNIPAAm), poly-hydroxyethylacrylate (pHEMA) pure and/or crosslinked and/or functionalized with azobenzene, poly(N,N-diethylacrylamide) (pDEEAm). The hydrogel layer 6 can be both temperature and humidity responsive. In one embodiment, the hydrogel material is Poly-N-vinylcaprolactam (pNVCL), which shows good response in aqueous mediums. Similar to other hydrogels, pNVCL is characterized by a lower critical solution temperature (LCST). Below the defined LCST, pNVCL shows high chance of volume, i.e. swelling. Above the LCST, pNVCL tends to expel its water content, resulting in gradual decrease in swelling. Conformal deposition of the hydrogel is preferred in order to ensure complete filling of the recesses. Conformal deposition can be carried out by initiated chemical vapour deposition (iCVD). This technique can allow deposition of high quality hydrogels directly from a vapour phase. Controlling process parameters, such as filament temperature, can provide control over the LCST. Additionally, controlling the pm/psat (fractional monomer pressure at the substrate temperature) of the inflowing monomers can result in highly conformal depositions. With iCVD it can be possible to deposit pNVCL with several percentages of Di(ethylene glycol) divinylether (DEGDVE) as crosslinker. Each composition can correspond to a different LCST and swelling ratio. A crosslinked pNVCL-co-DEGDVE can be stable in high humidity medium, in contrast to pure pNVCL, which can dissolve in high humidity.

Fig. 6 shows a SEM image of recesses 4a in the patterned resin layer 4, wherein the recesses 4a are filled with piezoelectric material and hydrogel, in order to create the piezoelectric layer (5) and the layer of multi-stimuli sensitive hydrogel (6).

Step h) includes creating a second electrode layer 7 by depositing electrical conductive material on the layer of multi-stimuli sensitive hydrogel 6 obtained in step g) in order to obtain a top electrode. In one embodiment, a 50 nm silver layer can be deposited by e-beam evaporation.

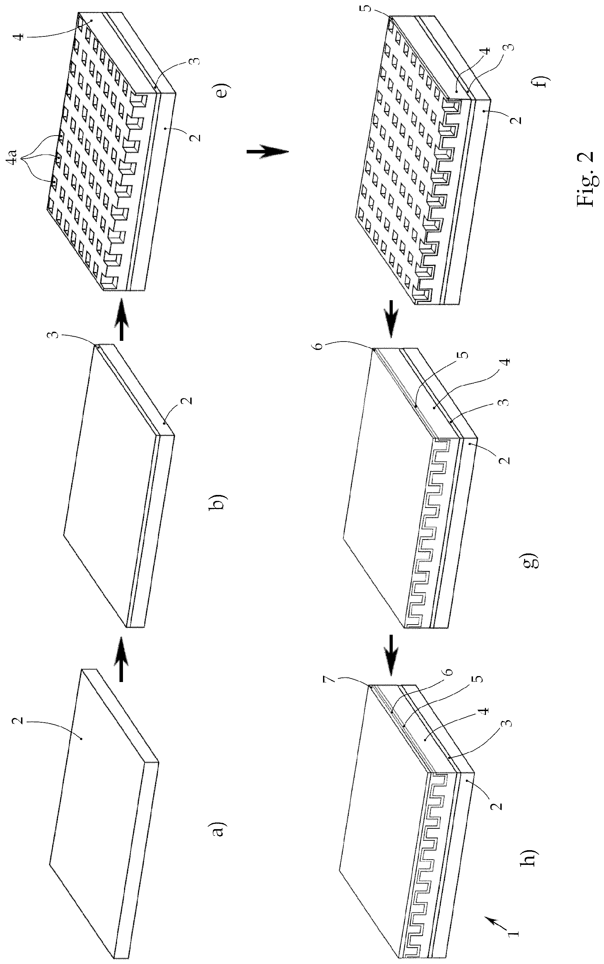

Fig. 2 shows a perspective view of the production steps of the multi-stimuli sensor shown in Fig. 1. Each step shown in Fig. 2 corresponds to the a similar referenced step shown in Fig. 1.

As can be seen in Fig. 2e and the following Fig. 2f to 2h a pattern of recesses 4a (which can be referred to as a nanorods), with walls comprising piezoelectric material and filled with hydrogel, is arranged on a substrate layer 3 and connected via top and bottom electrodes. A detailed view of one nanorod is also shown in Fig. 3.

Fig. 3 shows one recess of a multi-stimuli sensor device 1, wherein the recess can be referred to as a nanorod as well. The nanorod comprises of a recess 4a in a piezoelectric material, wherein said recess is filled with a hydrogel 6. The nanorod is shown in a non-stimulated state (left) and a stimulated state (right). Due to stimulation, the hydrogel expands, which causes a mechanical deformation of the piezoelectric material, which creates a detectable piezoelectric charge.

### Results:

### Response to force/pressure:

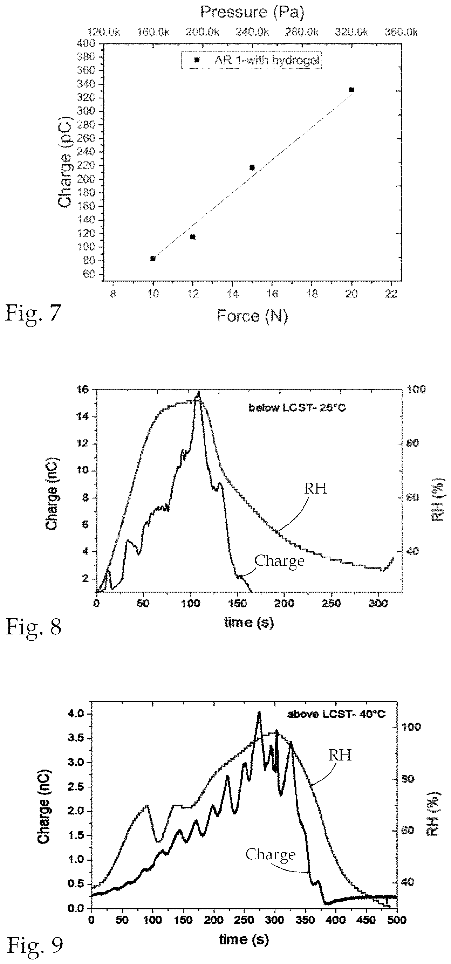

Fig. 7 shows a graph of generated piezoelectric charge as a function of applied force/pressure. The sensor response to force/pressure is tested with a piezoelectric measurement setup. The setup is composed of a pneumatic stamp generating a step force signal with magnitude of 10 N, 12 N, 15 N and 20 N at a frequency of 0.5 Hz, equivalent to an applied pressure of 160, 190, 240 and 320 kPa, respectively. The generated piezoelectric current is measured with a PXI-controller and the charge is calculated from the integrated piezoelectric current signal.

### Response to humidity:

The sensor response to humidity was tested in an environmental chamber (ESPEC, SH-222), where a direct measurement of the charge was performed with a DEWESoft DAQ system.

Fig. 8 shows a graph of generated piezoelectric charge in response to humidity at 25°C (below LCST). Both charge and humidity are plotted as a function of time.

Fig. 9 shows a graph of generated piezoelectric charge in response to humidity at 40°C (above LCST). Both charge and humidity are plotted as a function of time. It can be concluded, that the generated charge is higher below the LCST, as the hydrogel shows higher swelling.

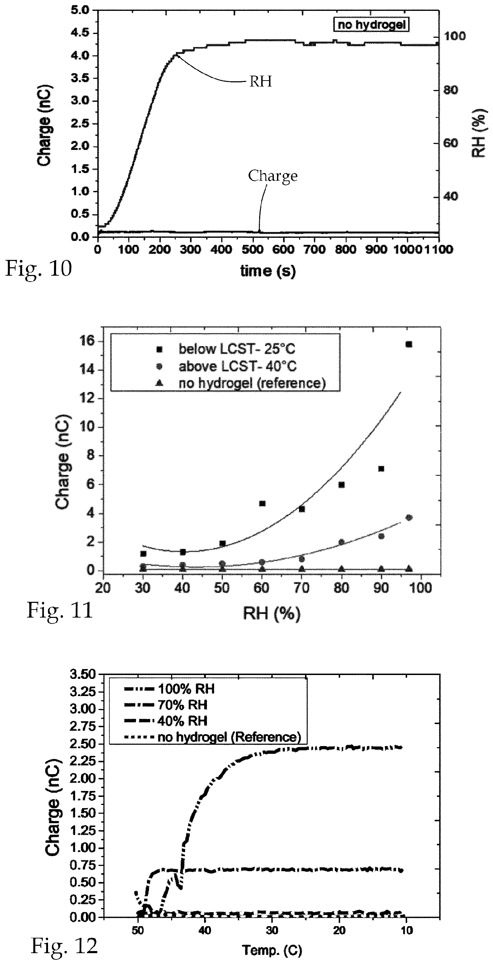

Fig. 10 shows a reference measurement is done with a sensor lacking a hydrogel layer, to ensure that the measured response is related to the hydrogel swelling.

Fig. 11 shows a graph of generated piezoelectric charge as a function of humidity at 25°C and 40°C. Values at different RH% are extracted from measurements shown in Fig. 8, 9 and 10.

### Response to temperature:

The sensor response to temperature is measured with the setup described in section "Response to humidity". The response is measured as a function of temperature, for a range between 50 - 0°C at 40 and 70 and 100 RH%. Additionally, a reference measurement was performed at 100 RH% using a sensor with no hydrogel layer.

Fig. 12 shows a graph of generated piezoelectric charge as a function of temperature at different RH%. The device was cooled from 50 to 10°C at 40, 70 and 100 RH%. The response of a reference sample is also plotted.

Of course, the invention is not limited to the examples given in this specification, which merely show embodiments of the invention that can be carried out by a person skilled in the art in view of this disclosure.

## Claims

1. Method for producing a multi-stimuli sensor device (1), said method comprising the following steps:
a) providing a substrate layer (2) consisting of flexible material, in particular PET (Polyethylene terephtalate) and/or PDMS (Polydimethylsiloxan) or mixtures thereof, the substrate layer (2) having a first side for receiving an electrode,
b) creating a first electrode layer (3) by depositing electrical conductive material on the substrate layer (2) of step a) in order to obtain a bottom electrode,
c) creating a flexible resin layer by depositing UV-curable resin on top of the first electrode layer (3) of step b),
d) creating a pattern of recesses (4a) in the flexible resin layer of step c) by pressing a stamp having multiple protrusions into the flexible resin layer of step c), wherein each recess (4a) corresponds with a protrusion of the stamp,
e) curing the patterned flexible resin layer obtained in step d) by irradiating UV light onto said patterned resin layer (4) and removing the stamp,
f) creating a piezoelectric layer (5) on top of the cured patterned resin layer (4) obtained in step e) by coating the surface of the patterned resin layer (4) including its recesses (4a) with a layer of piezoelectric material,
g) creating a layer of multi-stimuli sensitive hydrogel (6) on top of the piezoelectric layer (5) obtained in step f) by applying multi-stimuli sensitive hydrogel on the piezoelectric layer (5) of step f) fully filling the coated recesses (4a) of the piezoelectric layer (5),
h) creating a second electrode layer (7) by depositing electrical conductive material on the layer of multi-stimuli sensitive hydrogel (6) obtained in step g) in order to obtain a top electrode.

2. Method according to claim 1, wherein the electrical conductive material deposited in step b) and or h) to create the respective electrode consists of gold, silver or mixtures thereof.

3. Method according to any of the preceding claims, wherein the UV-curable resin deposited in step c) is a compound based on acrylates, in particular methaacrylates, e.g. polyurethane acrylate (PUA).

4. Method according to any of the preceding claims, wherein the substrate layer (2) consists of flexible synthetic material.

5. Method according to any of the preceding claims, wherein the first side of the substrate layer (2) is essentially flat shaped.

6. Method according to any of the preceding claims, wherein the piezoelectric layer (5) of step f) has a thickness of at least 10 nm and preferably a maximum thickness of 60% of the diameter of the corresponding recess of step d).

7. Method according to any of the preceding claims, wherein the piezoelectric layer (5) consists of zinc oxide or polyvinylidenfluoride.

8. Method according to any of the preceding claims, wherein the piezoelectric layer (5) is created by using initiated Chemical Vapor Deposition (iCVD) or atomic layer deposition, in particular plasma enhanced atomic layer deposition (PEALD).

9. Method according to any of the preceding claims, wherein the hydrogel of step g) is selected from the following group of hydrogels: poly N-Vinyl Caprolactame (pNVCL), poly-N-isopropylacrylamide (pNIPAAm), poly-hydroxyethylacrylate (pHEMA) pure and/or crosslinked and/or functionalized with azobenzene, poly(N,N-diethylacrylamide) (pDEEAm).

10. Method for producing multi-stimuli sensitive and high resolution artificial skin device, said method comprising the following step:
a) producing the artificial skin device by producing an array of mechanically connected multi-stimuli sensor devices (1), wherein each multi-stimuli sensor device is obtained by a method according to any of the preceding claims and wherein the substrate layer (2) extends along all the multi-stimuli device as a single piece thus mechanically connecting neighbouring multi-stimuli sensor devices (1) with each other, wherein the bottom electrodes of multi-stimuli sensor devices are separated from neighbouring bottom electrodes of multi-stimuli sensor devices and/or wherein the top electrodes of multi-stimuli sensor devices are separated from neighbouring top electrodes of multi-stimuli sensor devices, wherein each multi-stimuli sensor device (1) has a sensing surface area below 1mm².

11. Multi-stimuli sensor device (1) comprising:
- a substrate layer (2) consisting of flexible material, in particular PET (Polyethylene terephtalate) and/or PDMS (Polydimethylsiloxan) or mixtures thereof, the substrate layer (2) having a first side for receiving an electrode,
- a first electrode layer (3) arranged on top of the substrate layer in order to obtain a bottom electrode,
- a flexible patterned resin layer (4) on top of the first electrode layer (3), having multiple recesses (4a) in the flexible resin layer,
- a piezoelectric layer (5) on top of the patterned resin layer (4), said piezoelectric layer (5) coating the surface of the patterned resin layer (4) including its recesses (4a) with a layer of piezoelectric material,
- a layer of multi-stimuli sensitive hydrogel (6) on top of the piezoelectric layer (5) fully filling the coated recesses (4a) of the piezoelectric layer (5),
- a second electrode layer (7) on top of the layer of multi-stimuli sensitive hydrogel (6) in order to obtain a top electrode.

12. Multi-stimuli sensitive artificial skin device comprising an array of mechanically connected multi-stimuli sensor devices (1), wherein each multi-stimuli sensor device (1) is obtained by a method according to any of the claims 1 to 9 and wherein the substrate layer (2) extends along all the multi-stimuli devices (1) as a single piece thus mechanically connecting neighbouring multi-stimuli sensor devices (1) with each other, wherein the bottom electrodes of multi-stimuli sensor devices are separated from neighbouring bottom electrodes of multi-stimuli sensor devices and/or wherein the top electrodes of multi-stimuli sensor devices are separated from neighbouring top electrodes of multi-stimuli sensor devices, wherein each multi-stimuli sensor device has a surface area below 1 mm².

13. Multi-stimuli sensitive artificial skin device according to claim 12, wherein the sensing surface of each multi-stimuli sensor device (1) is smaller than 1 mm².
